# EUROPÄISCHE PATENTSCHRIFT

(11) **EP 3 704 797 B1**
(45) Veröffentlichungstag und Bekanntmachung des Hinweises auf die Patenterteilung: **07.04.2021**
(21) Anmeldenummer: 18796023.2
(22) Anmeldetag: 31.10.2018
(51) Int. Cl.: H03K 17/16

(54) **SCHALTUNGSANORDNUNG UND LEISTUNGSELEKTRONISCHE WANDLERSCHALTUNG**
CIRCUIT ARRANGEMENT AND POWER ELECTRONIC CONVERTER CIRCUIT
AGENCEMENT DE CIRCUIT ET CIRCUIT DE TRANSDUCTEUR ÉLECTRONIQUE DE PUISSANCE

(30) Priorität: 01.11.2017 DE 102017125548
(43) Veröffentlichungstag der Anmeldung: 09.09.2020
(73) Patentinhaber: SMA Solar Technology AG, 34266 Niestetal (DE)
(72) Erfinder: FRIEBE, Jens, 34246 Vellmar (DE); PRIOR, Oliver, 34454 Bad Arolsen (DE); WAPPLER, Thomas, 34302 Guxhagen (DE)
(86) Internationale Anmeldenummer: PCT/EP2018/079790
(87) Internationale Veröffentlichungsnummer: WO 2019/086501

(56) Entgegenhaltungen:
- WO-A1-2004/102806
- DE-A1-102004 033 354
- DE-A1-102007 041 510

## Beschreibung

Die Erfindung betrifft eine Schaltungsanordnung umfassend einen Leistungshalbleiterschalter, eine Freilaufdiode, eine Speicherdrossel und eine Treiberschaltung. Weiterhin betrifft die Erfindung eine leistungselektronische Wandlerschaltung mit einer solchen Schaltungsanordnung sowie eine leistungselektronische Wandlerschaltung mit zwei solcher Schaltungsanordnungen.

Zur Erzeugung von Ansteuersignalen für einen Leistungshalbleiterschalter werden häufig digitale Schaltungen, beispielsweise insbesondere Mikroprozessoren, verwendet. Die von digitalen Schaltungen bereit gestellten Ausgangsströme oder Ausgangsspannungen sind in vielen Fällen jedoch nicht ausreichend, um einen Leistungshalbleiterschalter direkt anzusteuern. Daher werden Treiberschaltungen zwischen der digitalen Schaltung und dem Leistungshalbleiterschalter eingesetzt, die einen Strom und eine Spannung in erforderlicher Höhe bereitstellen.

In der Leistungselektronik liegt bei vielen Wandlerschaltungen eine Reihenschaltung zweier Leistungshalbleiter vor, welche abwechselnd einen Strom zwischen einem der Anschlusspunkte der Reihenschaltung und einem Verbindungspunkt zwischen den Leistungshalbleitern leiten. Infolgedessen springt das Potential an dem Verbindungspunkt zwischen den Werten der Potentiale an den Anschlusspunkten der Reihenschaltung in Abhängigkeit davon, welcher der Leistungshalbleiter gerade leitend ist. Diese Potentialsprünge können durchaus in der Größenordnung von mehreren hundert Volt liegen.

Für den Fall, dass einer der Leistungshalbleiter ein aktiv ansteuerbarer Leistungshalbleiterschalter ist, der über eine Treiberschaltung durch Anlegen einer Spannung zwischen dem Verbindungspunkt und einem Steueranschluss des Leistungshalbleiterschalter angesteuert wird, ist die Treiberschaltung mit dem an dem Verbindungspunkt somit für die Ansteuerung vorliegenden Bezugspotential verbunden. Dies hat zur Folge, dass auch innerhalb der Treiberschaltung, wie auch in dem Signal zur Ansteuerung des Leistungshalbleiterschalters, Potentialsprünge in der Größenordnung wie an dem Verbindungspunkt auftreten.

Insbesondere bei schnell schaltenden Leistungshalbleiterschaltern liegen dadurch große zeitliche Spannungsänderungen du/dt nicht nur am Leistungshalbleiterschalter, sondern auch an Komponenten der Treiberschaltung vor. Durch parasitäre Koppelkapazitäten an den Komponenten der Treiberschaltung treten in Folge dessen hohe unerwünschte Ströme auf. Eine übliche Gegenmaßnahme ist die Reduktion von Koppelkapazitäten. Hierbei kommt man jedoch bei schnell schaltenden Leistungshalbleiterschaltern und den damit verbundenen Treiberschaltungen an Grenzen aufgrund der räumlichen Ausdehnung der Komponenten. Die Reduktion der Koppelkapazitäten ist mit erheblichem Aufwand und somit hohen Kosten verbunden. Insbesondere gibt es nur eine eingeschränkte Auswahl an verwendbaren Bauteilen für den Einsatz in Verbindung mit modernen, schnell schaltenden Leistungshalbleiterschaltern.

Eine weitere mögliche Maßnahme ist es, die durch kapazitive Kopplung entstehenden unerwünschten Ströme durch Filtermaßnahmen zur eliminieren oder zu reduzieren, was ebenfalls mit zusätzlichem Aufwand und Kosten verbunden ist.

In der Druckschrift WO 2004/102806 A1 ist offenbart, im Fall von aufgrund parasitärer Induktivitäten bei Schaltvorgängen eines Leistungshalbleiterschalters induzierten Spannungen ein Bezugspotential und ein Steuersignal einer Treiberschaltung über ein Gleichtaktfilter mit dem Leistungshalbleiterschalter zu verbinden. Hintergrund ist hierbei die Aufgabe, eine gleichmäßige dynamische Stromaufteilung bei parallel geschalteten Leistungshalbleiterschaltern unter Verwendung nur einer einzigen Treiberschaltung zu erreichen. Das Gleichtaktfilter bedeutet auch hier zusätzlichen Aufwand und somit auch Kosten

DE 10 2007 041510 A1 offenbart einen bidirektionalen Gleichstromsteller mit einer Speicherdrossel und einer auf der Speicherdrossel aufgebrachten zusätzlichen Wicklung.

Der Erfindung liegt die Aufgabe zugrunde, eine Schaltungsanordnung der eingangs genannten Art und eine leistungselektronische Wandlerschaltung der eingangs genannten Art bereitzustellen, welche bei einer Reihenschaltung zweier Leistungshalbleiter eine Reduzierung von störenden Strömen aufgrund von Koppelkapazitäten ermöglicht.

Diese Aufgabe wird erfindungsgemäß gelöst durch eine Schaltungsanordnung gemäß dem unabhängigen Anspruch 1 sowie durch leistungselektronische Wandlerschaltungen gemäß den nebengeordneten Vorrichtungsansprüchen 13, 14 und 15. Vorteilhafte Ausgestaltungen der Erfindung sind in den abhängigen Ansprüchen beschrieben.

Eine Schaltungsanordnung der eingangs genannten Art umfasst einen Leistungshalbleiterschalter mit einem Steueranschluss, einem Bezugspotentialanschluss und einem gesteuerten Anschluss, eine Freilaufdiode, eine Speicherdrossel mit einer Wicklung zwischen einem ersten Drosselanschluss und einem zweiten Drosselanschluss sowie einem Kern, wobei die Speicherdrossel zur Führung eines über den Leistungshalbleiterschalter fließenden Stroms eingerichtet ist, und eine Treiberschaltung. Die Treiberschaltung ist zur Ansteuerung des Leistungshalbleiterschalters über dessen Steueranschluss eingerichtet. Die Ansteuerung erfolgt dabei durch Anlegen einer Spannung zwischen dem Steueranschluss und dem Bezugspotentialanschluss des Leistungshalbleiterschalters, wodurch ein Stromfluss von dem gesteuerten Anschluss zum Bezugspotentialanschluss gesteuert wird.

Der Steueranschluss kann beispielsweise ein Gateanschluss eines IGBTs (Isolated Gate Bipolar Transistor) oder eines MOSFETs (Metal Oxide Semiconductor Field Effect Transistor) sein, der Bezugspotentialanschluss ein Emitteranschluss des IGBTs oder ein Sourceanschluss des MOSFETs und der gesteuerte Anschluss ein Kollektoranschluss des IGBTs oder ein Drainanschluss des MOSFETs.

Bei einer Schaltungsanordnung der eingangs genannten Art ist der gesteuerte Anschluss des Leistungshalbleiterschalters mit einem ersten Anschlusspunkt verbunden und der Bezugspotentialanschluss des Leistungshalbleiterschalters mit einem Verbindungspunkt verbunden. Der Verbindungspunkt ist wiederum über die Freilaufdiode mit einem zweiten Anschlusspunkt verbunden, wobei die Freilaufdiode von dem Verbindungspunkt zu dem zweiten Anschlusspunkt in Sperrrichtung ausgerichtet ist. Weiterhin ist der Verbindungspunkt mit dem ersten Drosselanschluss verbunden und der zweite Drosselanschluss mit einem dritten Anschlusspunkt.

Eine Schaltungsanordnung der eingangs genannten Art findet sich beispielsweise in konventionellen unidirektionalen Hochsetzstellern oder Tiefsetzstellern.

Wenn dabei im Rahmen der vorliegenden Beschreibung und in den Patentansprüchen etwas als mit etwas anderem verbunden bezeichnet wird, ist damit immer eine direkte Verbindung gemeint, das heißt eine Verbindung über eine Leitung mit idealerweise als gering angenommenem ohmschen Widerstand und als gering angenommener Induktivität oder über ein Bauteil, das im Vergleich zu einer solchen Leitung allenfalls vernachlässigbare zusätzliche Spannungsabfälle oder Stromänderungen verursacht, wie beispielsweise ein Messwiderstand (Shunt) oder eine durch Ferritperlen gebildete Impedanz. Eine andere Verbindung wird im Rahmen der vorliegenden Beschreibung und in den Patentansprüchen immer ausdrücklich als über ein Bauteil oder über eine Bauteileanordnung, beispielsweise über einen Widerstand oder über eine Diode oder beispielsweise über eine Reihenschaltung zweier Transistoren verbunden bezeichnet. Eine solche Verbindung ist dann auch immer nur ausschließlich über das genannte Bauteil oder die genannte Bauteileanordnung realisiert und nicht zusätzlich über weitere Bauteile, abgesehen von eventuell zusätzlichen Bauteilen, die allenfalls vernachlässigbare zusätzliche Spannungsabfälle oder Stromänderungen verursachen.

Erfindungsgemäß ist bei einer Schaltungsanordnung der eingangs genannten Art nun ein Bezugspotentialanschluss der Treiberschaltung direkt oder über eine Impedanz mit dem dritten Anschlusspunkt verbunden und es ist mindestens eine weitere Wicklung vorhanden, die mit der Wicklung der Speicherdrossel über den Kern induktiv gekoppelt ist. Die mindestens eine weitere Wicklung ist dabei zur Führung eines Signals der Treiberschaltung eingerichtet.

Der erfindungsgemäßen Schaltungsanordnung liegt die Erkenntnis zugrunde, dass bei dem Potential am dritten Anschlusspunkt im Vergleich zu dem Potential am Verbindungspunkt aufgrund der zwischengeschalteten Speicherdrossel deutlich geringere bzw. überhaupt keine Sprünge mehr auftreten, die sich auf Komponenten innerhalb der Treiberschaltung übertragen. Weiterhin ist die erfindungsgemäße Schaltungsanordnung vorteilhaft dahingehend, dass auch im Hinblick auf eine räumliche Platzierung der Komponenten der Treiberschaltung deutlich mehr Freiheiten bestehen, wohingegen bei einer nach dem Stand der Technik üblichen direkten Verbindung des Bezugspotentialanschlusses der Treiberschaltung mit dem Verbindungspunkt die Komponenten möglichst nah an dem Verbindungpunkt, und damit auch möglichst nah an dem Leistungshalbleiterschalter angeordnet sein müssen, um Koppelkapazitäten klein zu halten.

Über die bei der erfindungsgemäßen Schaltungsanordnung vorliegende induktive Kopplung der mindestens einen weiteren Wicklung mit der Wicklung der Speicherdrossel werden die Spannungsänderungen über der Wicklung der Speicherdrossel auf die mindestens eine weitere Wicklung übertragen, so dass dann bei Führung eines Signals der Treiberschaltung über die mindestens eine weitere Wicklung ein Signal am Steueranschluss des Leistungshalbleiterschalters anliegt, das gegenüber dem springenden Potential am Verbindungspunkt zu jedem Zeitpunkt die gleiche Potentialdifferenz aufweist wie ein von der Treiberschaltung vorgegebenes Ansteuersignal gegenüber dem ruhigen Potential am Bezugspotentialanschluss der Treiberschaltung.

Eine Speicherdrossel zur Führung eines über den Leistungshalbleiterschalter fließenden Stroms ist bei Schaltungsanordnungen in beispielsweise leistungselektronischen Wandlerschaltungen regelmäßig ohnehin vorhanden, so dass die erfindungsgemäß vorgesehene mindestens eine weitere Wicklung in vorteilhaft aufwandsarmer Weise auf den Kern der ohnehin vorhandenen Speicherdrossel aufgebracht werden kann. Da die mindestens eine weitere Wicklung lediglich zur Führung eines Signals der Treiberschaltung vorgesehen ist, braucht die mindestens eine weitere Wicklung im Gegensatz zur Wicklung der Speicherdrossel auch nicht für so große Ströme wie die über die Wicklung der Speicherdrossel fließenden Ströme ausgelegt sein.

In einer vorteilhaften Ausführungsform kann die mindestens eine weitere Wicklung derart mit der Wicklung der Speicherdrossel induktiv gekoppelt sein, dass sich ein Spannungsabfall über der Wicklung der Speicherdrossel zu einer Spannung des Signals gegenüber einem Bezugspotential am dritten Anschlusspunkt addiert. Der Übertragungsfaktor zwischen der Wicklung der Speicherdrossel und der mindestens einen weiteren Wicklung ist dazu zumindest näherungsweise 1:1.

Bei dieser Ausführungsform kann beispielsweise ein Ansteuersignal so wie es bei einem gemäß dem Stand der Technik direkten Anschluss des Bezugspotentialeingangs der Treiberschaltung an den Verbindungspunkt von der Treiberschaltung bereitgestellt wird direkt von der Treiberschaltung zum Steueranschluss des Leistungshalbleiterschalters über die mindestens eine weitere Wicklung geführt werden, ohne dass es vor oder nach der mindestens einen weiteren Wicklung zusätzlich speziell angepasst werden muss.

Das Signal kann, wie bereits erwähnt, ein Ansteuersignal für den Leistungshalbleiterschalter sein, also ein Signal, das den Leistungshalbleiterschalter über dessen Steueranschluss ansteuert. Gemäß einer weiteren vorteilhaften Ausgestaltung der Erfindung kann das Signal aber auch ein Spannungsversorgungssignal der Treiberschaltung sein, wobei dann entweder nur das Spannungsversorgungssignal über eine weitere Wicklung oder sowohl das Spannungsversorgungssignal als auch das Ansteuersignal über jeweils eine weitere Wicklung geführt ist.

Das Spannungsversorgungssignal kann sowohl ein positives als auch ein negatives Spannungsversorgungssignal sein. Es können somit auch zwei Spannungsversorgungssignale über dann jeweils eine weitere Wicklung geführt sein.

Das Potential des negativen Spannungsversorgungssignals ist bei Treiberschaltungen häufig mit dem Bezugspotential für ein Ansteuersignal identisch. In diesem Fall ist es vorteilhaft, bei Führung des negativen Spannungsversorgungssignals über eine weitere Wicklung die optionale Impedanz anstatt der direkten Verbindung zwischen dem Bezugspotentialanschluss der Treiberschaltung und dem dritten Anschlusspunkt vorzusehen, um nicht die weitere Wicklung für das negative Spannungsversorgungssignal für einen Strom in der Größenordnung des über die Wicklung der Speicherdrossel fließenden Stroms auslegen zu müssen. Die Impedanz kann beispielsweise eine Induktivität, eine Kapazität oder ein ohmscher Widerstand sein.

In einer vorteilhaften Ausführungsform kann das Signal auch ein Signal zwischen zwei Komponenten der Treiberschaltung sein. Das heißt, das Signal ist dann nicht mehr direkt von einem Signalanschluss der Treiberschaltung über die mindestens eine weitere Wicklung und eine Leitung dem Steueranschluss des Leistungshalbleiterschalters zugeführt.

Eine solche Schaltungsanordnung ist vorteilhaft im Hinblick auf eine größere Flexibilität bei der räumlichen Anordnung von Komponenten der Treiberschaltung, indem ein Teil der Komponenten nahe am Leistungshalbleiterschalter angeordnet werden kann und ein anderer Teil der Komponenten weiter entfernt vom Leistungshalbleiterschalter. Eine solche Schaltungsanordnung ist weiterhin vorteilhaft dahingehend, dass beispielweise eine Signalaufbereitung, insbesondere eine Anpassung, des Signals vor oder nach dem Durchfließen der mindestens einen weiteren Wicklung erfolgen kann. Hierdurch ergibt sich insbesondere eine größere Flexibilität in der Ausgestaltung der induktiven Kopplung zwischen der weiteren Wicklung und der Wicklung der Speicherdrossel.

Selbstverständlich können auch mehrere Signale zwischen zwei oder mehr Komponenten der Treiberschaltung über dann jeweils eine weitere Wicklung geführt sein. Die Verwendung von Zahlwörtern ist somit hier, wie grundsätzlich im Rahmen der vorliegenden Beschreibung und in den Patentansprüchen, im Sinne von mindestens dieser Anzahl zu verstehen. Die ausdrückliche Bezeichnung einer Anzahl als mindestens diese Anzahl dient an einigen Stellen lediglich einer zusätzlichen Verdeutlichung dieses Sachverhalts.

Eine erfindungsgemäße Schaltungsanordnung kann in einer weiteren Ausführungsform weiterhin einen weiteren Leistungshalbleiterschalter mit einem weiteren Steueranschluss, einem weiteren Bezugspotentialanschluss und einem weiteren gesteuerten Anschluss umfassen sowie eine weitere Treiberschaltung, die zur Ansteuerung des weiteren Leistungshalbleiterschalters mit dem weiteren Steueranschluss verbunden ist. Der weitere gesteuerte Anschluss ist dabei mit dem Verbindungspunkt verbunden und der weitere Bezugspotentialanschluss mit dem zweiten Anschlusspunkt. Weiterhin kann diese Ausführungsform eine weitere Freilaufdiode umfassen. Der erste Anschlusspunkt ist dabei über die weitere Freilaufdiode mit dem Verbindungspunkt verbunden, wobei die weitere Freilaufdiode von dem ersten Anschlusspunkt zu dem Verbindungspunkt in Sperrrichtung ausgerichtet ist.

Bei dieser Ausführungsform liegt eine antiparallele Verschaltung der Freilaufdiode und des weiteren Leistungshalbleiterschalters vor, das heißt die Durchflussrichtungen der Freilaufdiode und des weiteren Leistungshalbleiterschalters sind entgegengesetzt. Die Freilaufdiode kann in dem Fall auch eine intrinsische Diode des weiteren Leistungshalbleiterschalters sein, das heißt beispielsweise eine Bodydiode eines MOSFETs oder eine in ein Halbleitermodul eines IGBTs integrierte Diode. Die Freilaufdiode kann aber auch eine zusätzlich zu dem weiteren Leistungshalbleiterschalter antiparallel geschaltete Diode sein, unabhängig davon, ob der weitere Leistungshalbleiterschalter eine intrinsische Diode aufweist oder nicht.

Ebenso liegt bei dieser Ausführungsform eine antiparallele Verschaltung des Leistungshalbleiterschalters und der weiteren Freilaufdiode vor. Auch hierbei kann die weitere Freilaufdiode eine intrinsische Diode des Leistungshalbleiterschalters sein oder eine zusätzlich zu diesem antiparallel geschaltete Diode, unabhängig davon, ob der Leistungshalbleiterschalter eine intrinsische Diode aufweist oder nicht.

Bei dieser Ausführungsform mit einem weiteren Leistungshalbleiterschalter und einer weiteren Freilaufdiode liegt ferner eine Reihenschaltung zweier Leistungshalbleiterschalter mit jeweils einer antiparallel geschalteten Freilaufdiode vor, wobei an einen Verbindungspunkt eine Speicherdrossel angeschlossen ist. Die erfindungsgemäße Ausführungsform stellt damit eine erfindungsgemäße Weiterentwicklung einer Schaltungsanordnung dar, wie sie sich beispielsweise in konventionellen bidirektionalen Hochsetzstellern oder Tiefsetzstellern, sogenannten Synchronwandlern, findet, sowie in Halbbrückenschaltungen in Wechselrichtern oder Gleichrichtern.

Eine weitere vorteilhafte Ausgestaltung der Erfindung kann vorsehen, dass die induktive Kopplung zwischen der Wicklung der Speicherdrossel und der mindestens einen weiteren Wicklung derart ausgestaltet ist, dass bei vollständiger oder partieller Sättigung des Kerns die Kopplung derart reduziert wird, dass eine Differenzspannung entsteht, die direkt oder über eine der Komponenten der Treiberschaltung bewirkt, dass der Leistungshalbleiterschalter ausgeschaltet wird oder in einem linearen Betriebspunkt gehalten wird.

Hierdurch wird im Fehlerfall das Auftreten eines zu großen Stroms innerhalb der Schaltungsanordnung oder ein Betrieb der Schaltungsanordnung mit gesättigtem Kern automatisch unterbunden.

Weiterhin kann bei einer vorteilhaften Ausgestaltung der erfindungsgemäßen Schaltungsanordnung die induktive Kopplung zwischen der Wicklung der Speicherdrossel und der mindestens einen weiteren Wicklung derart ausgestaltet sein, dass die mindestens eine weitere Wicklung eine Versorgungsleistung für die Treiberschaltung bereitstellt.

Die für die Treiberschaltung benötigte Versorgungsleistung ist im Vergleich zur der aufgrund des Stromflusses über die Speicherdrossel transportierten Leistung nur gering, so dass die Versorgungsleistung für die Treiberschaltung über die mindestens eine weitere Wicklung hiervon abgezweigt werden kann, ohne die Funktion der Schaltungsanordnung wesentlich zu beeinflussen.

Es kann auch als vorteilhaft angesehen werden, dass der zweite Drosselanschluss mit dem dritten Anschlusspunkt über einen Messwiderstand verbunden ist. Dabei ist dann der zweite Drosselanschluss mit einem Messanschluss der Treiberschaltung verbunden.

Hierdurch lässt sich, im Gegensatz zu einer Treiberschaltung deren Bezugspotentialanschluss gemäß dem Stand der Technik mit dem Verbindungspunkt verbunden ist, relativ aufwandsarm der durch die Speicherdrossel fließende Strom messen und beispielsweise für eine Regelung innerhalb der Treiberschaltung verwenden.

In einer weiteren vorteilhaften Ausführungsform der erfindungsgemäßen Schaltungsanordnung kann zwischen dem ersten Anschlusspunkt und dem zweiten Anschlusspunkt eine Kapazität angeschlossen sein.

Eine solche Kapazität kann eine Glättung der Spannung zwischen dem ersten Anschlusspunkt und dem zweiten Anschlusspunkt bewirken, was bei Verwendung der erfindungsgemäßen Schaltungsanordnung in einer leistungselektronischen Wandlerschaltung vorteilhaft ist. Die Kapazität kann auch eine über den ersten Anschlusspunkt und den zweiten Anschlusspunkt fließende Energie zwischenspeichern, das heißt, sie erfüllt dann die Funktion eines Spannungszwischenkreises.

In einer noch weiteren vorteilhaften Ausführungsform der erfindungsgemäßen Schaltungsanordnung kann zwischen dem dritten Anschlusspunkt und dem zweiten Anschlusspunkt oder alternativ in einer noch weiteren vorteilhaften Ausführungsform zwischen dem dritten Anschlusspunkt und dem ersten Anschlusspunkt eine Kapazität angeschlossen sein.

Diese Kapazitäten können ebenfalls eine Glättung der Spannung zwischen den Anschlusspunkten, zwischen denen sie angeschlossen sind, bewirken oder die über diese Anschlusspunkte fließende Energie zwischenspeichern.

Eine weitere Aufgabe der Erfindung ist es, eine leistungselektronische Wandlerschaltung der eingangs genannten Art mit einer Schaltungsanordnung der eingangs genannten Art bereitzustellen, mit welcher bei einer Reihenschaltung zweier Leistungshalbleiter eine Reduzierung von störenden Strömen aufgrund von Koppelkapazitäten ermöglicht ist.

Die erfindungsgemäße Aufgabe wird bei einer leistungselektronischen Wandlerschaltung der eingangs genannten Art mit einer Schaltungsanordnung der eingangs genannten Art dadurch gelöst, dass die Schaltungsanordnung nach einem der Ansprüche 1 bis 12 ausgebildet ist.

Eine erfindungsgemäße leistungselektronische Wandlerschaltung umfasst eine erfindungsgemäße Schaltungsanordnung gemäß einer der zuvor beschriebenen Ausführungsformen. Die leistungselektronische Wandlerschaltung kann dabei beispielsweise ein Hochsetzsteller, ein Tiefsetzsteller, ein Synchronwandler, ein Gleichrichter oder ein Wechselrichter sein. Die Anschlusspunkte der Schaltungsanordnung bilden dann Eingangs- bzw. Ausgangsanschlüsse der leistungselektronischen Wandlerschaltung.

Eine weitere Aufgabe der Erfindung ist es, eine leistungselektronische Wandlerschaltung der eingangs genannten Art mit zwei Schaltungsanordnung der eingangs genannten Art bereitzustellen, mit welcher bei einer Reihenschaltung zweier Leistungshalbleiter eine Reduzierung von störenden Strömen aufgrund von Koppelkapazitäten ermöglicht ist.

Die erfindungsgemäße Aufgabe wird bei einer leistungselektronischen Wandlerschaltung der eingangs genannten Art mit zwei Schaltungsanordnung der eingangs genannten Art dadurch gelöst, dass die Schaltungsanordnungen nach einem der Ansprüche 1 bis 11 ausgebildet sind, wobei die dritten Anschlusspunkte der beiden Schaltungsanordnungen miteinander verbunden sind und die zweiten Anschlusspunkte der beiden Schaltungsanordnungen miteinander verbunden sind, oder alternativ die zwei Schaltungsanordnungen jeweils nach einem der Ansprüche 1 bis 10 oder 12 ausgebildet sind, wobei die dritten Anschlusspunkte der beiden Schaltungsanordnungen miteinander verbunden sind und die ersten Anschlusspunkte der beiden Schaltungsanordnungen miteinander verbunden sind.

Die miteinander verbundenen Anschlusspunkte bilden Eingangs- bzw. Ausgangsanschlüsse der leistungselektronischen Wandlerschaltungen. Ebenso bilden die verbleibenden Anschlusspunkte, das heißt die ersten oder zweiten Anschlusspunkte, die optional auch miteinander verbunden sein können, Eingangs- bzw. Ausgangsanschlüsse der leistungselektronischen Wandlerschaltungen. Selbstverständlich kann eine erfindungsgemäße leistungselektronische Wandlerschaltung auch mehr als zwei erfindungsgemäße Schaltungsanordnungen umfassen, deren Anschlusspunkte dann in der beschriebenen Art jeweils miteinander verbunden sind.

Eine erfindungsgemäße leistungselektronische Wandlerschaltung mit einer Verschaltung von zwei oder mehr erfindungsgemäßen Schaltungsanordnungen in der zuvor beschriebenen Form kann beispielsweise als sogenannter Interleavingwandler betrieben werden, indem die Leistungshalbleiterschalter und die weiteren Leistungshalbleiterschalter einer jeweiligen Schaltungsanordnung zeitversetzt gegenüber den entsprechenden Leistungshalbleiterschaltern und weiteren Leistungshalbleiterschaltern der anderen Schaltungsanordnungen angesteuert werden. Hier zeigt sich als besonderer Vorteil der erfindungsgemäßen Schaltungsanordnung, dass der Bezugspotentialanschluss der Treiberschaltungen aller Leistungshalbleiterschalter jeweils mit dem gemeinsamen dritten Anschlusspunkt verbunden ist und somit die Treiberschaltungen alle ein gleiches Bezugspotential aufweisen und nicht wie gemäß dem Stand der Technik aufgrund einer Verbindung mit dem jeweiligen Verbindungspunkt ein jeweils unterschiedliches Bezugspotential. Dadurch können gegebenenfalls Teile der Treiberschaltungen der zwei oder mehr Schaltungsanordnungen gemeinsam für alle Schaltungsanordnungen genutzt werden.

Die erfindungsgemäßen leistungselektronischen Wandlerschaltungen mit einer Verschaltung von zwei oder mehr erfindungsgemäßen Schaltungsanordnungen in der zuvor beschriebenen Form können beispielsweise ein Hochsetzsteller, ein Tiefsetzsteller, ein Synchronwandler, ein Gleichrichter oder ein Wechselrichter sein.

Weitere zweckmäßige Ausgestaltungen und Vorteile der Erfindung sind Gegenstand der Beschreibung von Ausführungsformen der Erfindung unter Bezug auf die Figur der Zeichnungen. Die Zeichnungen dienen hierbei der Veranschaulichung von Ausführungsformen der Erfindung, beschränken die Erfindung aber nicht auf die gezeigten Merkmale.
Fig. 1 zeigt schematisch eine leistungselektronische Wandlerschaltung gemäß einem ersten Ausführungsbeispiel der Erfindung mit einer erfindungsgemäßen Schaltungsanordnung in einer Ausbildung als Tiefsetzsteller,
Fig. 2 zeigt schematisch eine leistungselektronische Wandlerschaltung gemäß einem zweiten Ausführungsbeispiel der Erfindung mit einer erfindungsgemäßen Schaltungsanordnung in einer Ausbildung als Hochsetzsteller,
Fig. 3 zeigt schematisch eine leistungselektronische Wandlerschaltung gemäß einem dritten Ausführungsbeispiel der Erfindung mit einer erfindungsgemäßen Schaltungsanordnung in einer Ausbildung als Synchronwandler,
Fig. 4 zeigt schematisch eine leistungselektronische Wandlerschaltung gemäß einem vierten Ausführungsbeispiel der Erfindung mit zwei erfindungsgemäßen Schaltungsanordnungen in einer Ausbildung als bidirektionaler Interleaved Hochsetzsteller, und
Fig. 5 zeigt schematisch eine leistungselektronische Wandlerschaltung gemäß einem fünften Ausführungsbeispiel der Erfindung mit zwei erfindungsgemäßen Schaltungsanordnungen in einer Ausbildung als unidirektionaler Interleaved Hochsetzsteller.

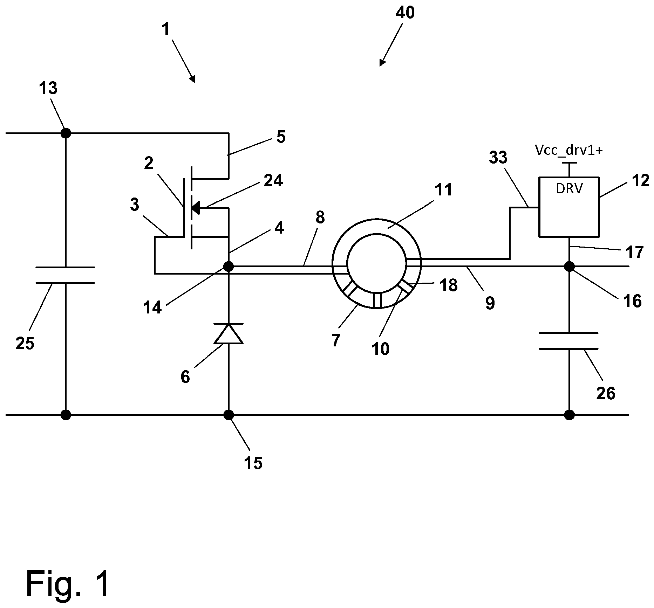

Fig. 1 zeigt eine erfindungsgemäße leistungselektronische Wandlerschaltung 40 mit einer erfindungsgemäßen Schaltungsanordnung 1. Ein gesteuerter Anschluss 5 eines Leistungshalbleiterschalters 2, der hier als MOSFET ausgeführt ist, ist mit einem ersten Anschlusspunkt 13 verbunden und ein Bezugspotentialanschluss 4 mit einem Verbindungspunkt 14. Zwischen dem Verbindungspunkt 14 und einem zweiten Anschlusspunkt 15 ist eine Freilaufdiode 6 angeschlossen, die von dem Verbindungspunkt 14 zu dem zweiten Anschlusspunkt 15 in Sperrrichtung ausgerichtet ist. Von dem Verbindungspunkt 14 zweigt eine Verbindung zu einem ersten Drosselanschluss 8 einer Speicherdrossel 7 ab, die eine Wicklung 10 zwischen dem ersten Drosselanschluss 8 und einem zweiten Drosselanschluss 9 aufweist, welche auf einen Kern 11 gewickelt ist. Bei geschlossenem Leistungshalbleiterschalter 2 fließt der über den Leistungshalbleiterschalter 2 fließende Strom auch über die Wicklung 10 der Speicherdrossel 7 und von dem zweiten Drosselanschluss 9 weiter zu einem mit dem zweiten Drosselanschluss 9 verbundenen dritten Anschlusspunkt 16.

Bei der erfindungsgemäßen Schaltungsanordnung 1 ist eine Treiberschaltung 12 vorhanden, die an einem Signalanschluss 33 ein Signal zur Ansteuerung eines Leistungshalbleiterschalters, beispielsweise ein pulsweitenmoduliertes Signal (PWM-Signal), bereitstellt, welches zwischen einem an einem Bezugspotentialanschluss 17 der Treiberschaltung 12 anliegenden Bezugspotential und einem hiervon unterschiedlichen Potential, beispielsweise dem Potential eines Spannungsversorgungssignals Vcc_drv1+ der Treiberschaltung 12, wechselt. Der Bezugspotentialanschluss 17 ist mit dem dritten Anschlusspunkt 16 direkt verbunden. Auf den Kern 11 ist eine weitere Wicklung 18 aufgebracht, die an ihrem einen Ende mit dem Signalanschluss 33 und an ihrem anderen Ende mit einem Steueranschluss 3 des Leistungshalbleiterschalters 2 verbunden ist, so dass das Signal über die weitere Wicklung 18 geführt wird.

Die induktive Kopplung zwischen der Wicklung 10 und der weitere Wicklung 18 ist beispielsweise so realisiert, dass eine ideale Kopplung mit vernachlässigbaren Streuverlusten, also ein Kopplungsfaktor von zumindest näherungsweise 1, vorliegt. In dem Fall addiert sich bei der in Fig. 1 vorliegenden gleichsinnigen Wicklung der Wicklung 10 und der weiteren Wicklung 18 auf den Kern 11 ein Spannungsabfall über der Wicklung 10 der Speicherdrossel 7 zu einer Spannung des Signals gegenüber einem Bezugspotential am dritten Anschlusspunkt 16.

Die weitere Wicklung 18 erfordert eine Auslegung lediglich für eine durch das Signal verursachte Stromstärke, welche in der Regel deutlich geringer ist als die Stromstärke eines durch den Leistungshalbleiterschalter 2 und somit durch die Wicklung 10 der Speicherdrossel 7 fließenden Stroms. Ein Leitungsquerschnitt der weiteren Wicklung 18 kann daher bei einer erfindungsgemäßen Schaltungsanordnung 1 deutlich geringer sein als ein Leitungsquerschnitt der Wicklung 10 der Speicherdrossel 7.

Bei der Schaltungsanordnung 1 in Fig. 1 ist zwischen dem ersten Anschlusspunkt 13 und dem zweiten Anschlusspunkt 15 eine Kapazität 25 angeschlossen, die hier beispielsweise einen Gleichspannungszwischenkreis bildet. Zwischen dem dritten Anschlusspunkt 16 und dem zweiten Anschlusspunkt 15 ist ebenfalls eine Kapazität 26 angeschlossen, die hier beispielsweise zur Glättung der Spannung zwischen dem dritten Anschlusspunkt 16 und dem zweiten Anschlusspunkt 15 dient.

Die in Fig. 1 dargestellte leistungselektronische Wandlerschaltung 40 bildet gemäß dem dargestellten Ausführungsbeispiel einen Tiefsetzsteller, der eine Spannung zwischen dem ersten Anschlusspunkt 13 und dem zweiten Anschlusspunkt 15, die in diesem Fall Eingangsanschlüsse bilden, in eine geringere Spannung zwischen dem dritten Anschlusspunkt 16 und dem zweiten Anschlusspunkt 15, die in diesem Fall Ausgangsanschlüsse bilden, umsetzen kann.

Dem Schaltungssymbol des hier beispielsweise als MOSFET ausgebildeten Leistungshalbleiterschalters 2 ist zu entnehmen, dass dieser eine Bodydiode aufweist, die von dem ersten Anschlusspunkt 13 zu dem Verbindungspunkt 14 in Sperrrichtung ausgerichtet ist. Die Schaltungsanordnung 1 weist somit durch die intrinsische Diode des MOSFETs eine weitere Freilaufdiode 24 auf, die allerdings für die Funktion der leistungselektronischen Wandlerschaltung 40 als Tiefsetzsteller nicht unbedingt erforderlich ist.

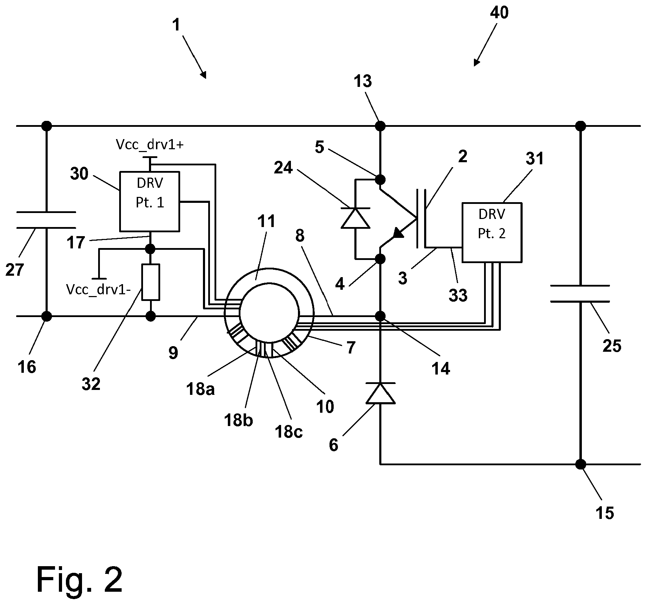

Fig. 2 zeigt eine leistungselektronische Wandlerschaltung 40 gemäß einem zweiten Ausführungsbeispiel der Erfindung mit einer erfindungsgemäßen Schaltungsanordnung 1. Bei der erfindungsgemäßen leistungselektronischen Wandlerschaltung 40 mit einer erfindungsgemäßen Schaltungsanordnung 1 gemäß dem Ausführungsbeispiel der Fig. 2 sind der Leistungshalbleiterschalter 2, die Freilaufdiode 6 und die Speicherdrossel 7 in gleicher Weise zwischen dem ersten Anschlusspunkt 13, dem zweiten Anschlusspunkt 15, dem dritten Anschlusspunkt 16 und dem Verbindungspunkt 14 angeordnet wie bei der Schaltungsanordnung 1 in Fig. 1. Der Leistungshalbleiterschalter 2 ist hier als IGBT ausgeführt.

Die Treiberschaltung umfasst in diesem Ausführungsbeispiel eine erste Komponente 30 und eine zweite Komponente 31. Ein Bezugspotentialanschluss 17 der ersten Komponente 30 ist über eine Impedanz 32 mit dem dritten Anschlusspunkt 16 verbunden. Die Impedanz 32 kann beispielsweise eine Induktivität, eine Kapazität oder ein ohmscher Widerstand sein. Ein Signalanschluss 33 der zweiten Komponente 31 ist mit dem Steueranschluss 3 des Leistungshalbleiterschalters 2 verbunden.

Auf den Kern 11 der Speicherdrossel 7 sind im vorliegenden Ausführungsbeispiel drei weitere Wicklungen 18a, 18b, 18c aufgebracht, die mit der Wicklung 10 der Speicherdrossel 7 induktiv gekoppelt sind. Über die weiteren Wicklungen 18a, 18b, 18c werden jeweils Signale zwischen den zwei Komponenten 30, 31 der Treiberschaltung geführt. Eines der Signale zwischen den zwei Komponenten 30, 31 ist beispielsweise ein positives Spannungsversorgungssignal Vcc_drv1+ der Treiberschaltung, ein anderes Signal zwischen den zwei Komponenten 30, 31 ist beispielsweise ein negatives Spannungsversorgungssignal Vcc_drv1- der Treiberschaltung, welches hier beispielsweise aufgrund der vorliegenden direkten Verbindung der zugehörigen Signalleitung mit dem Bezugspotentialanschluss 17 dem Bezugspotential der Treiberschaltung entspricht.

In dem Ausführungsbeispiel in Fig. 2 sind drei Signale zwischen zwei Komponenten 30, 31 jeweils über weitere Wicklungen 18a, 18b, 18c geführt. Es können in weiteren Ausführungsbeispielen der Erfindung auch nur ein Signal oder zwei Signale oder mehr als drei Signale über jeweils weitere Wicklungen zwischen zwei Komponenten geführt sein. Ebensogut können ein oder mehrere Signale auch zwischen mehr als zwei Komponenten einer Treiberschaltung über jeweils weitere Wicklungen geführt sein.

In dem Ausführungsbeispiel in Fig. 2 sind ferner sowohl das positive Spannungsversorgungssignal Vcc_drv1+ als auch das negative Spannungsversorgungssignal Vcc_drv1- über jeweils eine weitere Wicklung 18a, 18c geführt. Es kann in anderen Ausführungsbeispielen auch nur entweder das positive Spannungsversorgungssignal Vcc_drv1+ oder das negative Spannungsversorgungssignal Vcc_drv1- über eine weitere Wicklung geführt sein. Die Spannungsversorgungssignale können auch die einzigen Signale sein, die über weitere Wicklungen geführt sind.

Insbesondere bei einer Treiberschaltung mit zwei oder mehr Komponenten können über die weiteren Wicklungen geführte Signale vor oder nach der Führung über die weiteren Wicklungen geeignet angepasst oder aufbereitet werden, so dass beispielsweise auch bei nicht idealer Kopplung zwischen der oder den weiteren Wicklungen ein Signal am Steueranschluss 3 des Leistungshalbleiterschalters 2 anliegt, das zur Ansteuerung des Leistungshalbleiterschalters 2 geeignet ist.

Bei der Schaltungsanordnung 1 in Fig. 2 ist zwischen dem ersten Anschlusspunkt 13 und dem zweiten Anschlusspunkt 15 eine Kapazität 25 angeschlossen und zwischen dem dritten Anschlusspunkt 16 und dem ersten Anschlusspunkt 13 eine Kapazität 27 angeschlossen. Die leistungselektronische Wandlerschaltung 40 bildet dann in dem vorliegenden Ausführungsbeispiel einen Hochsetzsteller, der eine Spannung zwischen dem ersten Anschlusspunkt 13 und dritten Anschlusspunkt 16, die in diesem Fall Eingangsanschlüsse bilden, in eine höhere Spannung zwischen dem ersten Anschlusspunkt 13 und dem zweiten Anschlusspunkt 15, die in diesem Fall Ausgangsanschlüsse bilden, umsetzen kann.

Zu dem hier beispielsweise als IGBT ausgebildeten Leistungshalbleiterschalter 2 ist eine weitere Freilaufdiode 24 parallel geschaltet, die von dem ersten Anschlusspunkt 13 zu dem Verbindungspunkt 14 in Sperrrichtung ausgerichtet ist. Diese weitere Freilaufdiode 24 kann eine intrinsische Diode des IGBTs sein, das heißt beispielsweise eine in ein Halbleitermodul des IGBTs integrierte Diode, sie kann aber auch extern zu dem IGBT parallel geschaltet sein. Für die Funktion der leistungselektronischen Wandlerschaltung 40 als Hochsetzsteller ist die weitere Freilaufdiode 24 allerdings nicht unbedingt erforderlich ist.

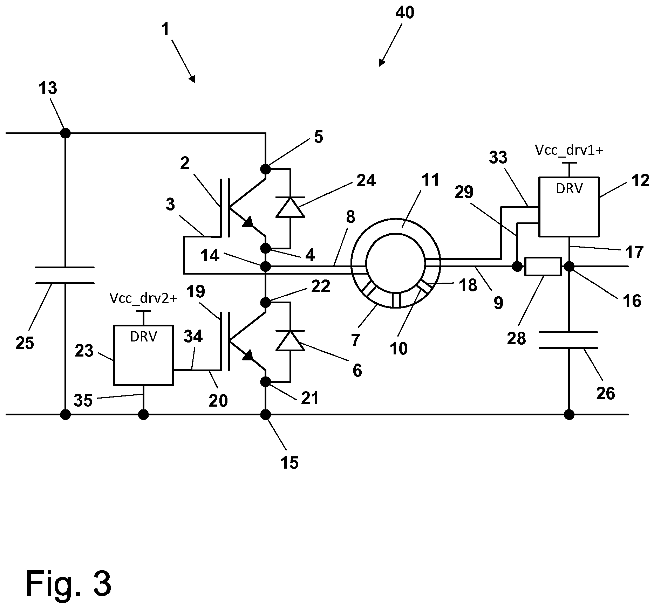

Fig. 3 zeigt eine leistungselektronische Wandlerschaltung 40 gemäß einem dritten Ausführungsbeispiel der Erfindung mit einer erfindungsgemäßen Schaltungsanordnung 1. Bei dem Ausführungsbeispiel einer leistungselektronischen Wandlerschaltung 40 mit einer erfindungsgemäßen Schaltungsanordnung 1 der Fig. 3 ist gegenüber dem Ausführungsbeispiel in Fig. 1 zu der Freilaufdiode 6 ein weiterer Leistungshalbleiterschalter 19 parallel geschaltet, dessen weiterer gesteuerter Anschluss 22 mit dem Verbindungspunkt 14 verbunden ist und dessen weiterer Bezugspotentialanschluss 21 mit dem zweiten Anschlusspunkt 15 verbunden ist. Ein weiterer Steueranschluss 20 ist mit einem weiteren Signalanschluss 34 einer weiteren Treiberschaltung 23 verbunden und ein weiterer Bezugspotentialanschluss 35 der weiteren Treiberschaltung 23 ist mit dem zweiten Anschlusspunkt 15 verbunden. Eine solche direkte Verbindung des Bezugspotentialanschlusses 35 der weiteren Treiberschaltung 23 mit dem Bezugspotentialanschluss 21 des weiteren Leistungshalbleiterschalters 19 ist hier problemlos möglich, da an dem zweiten Anschlusspunkt 15 keine Potentialsprünge auftreten.

Die Treiberschaltung 12 und die weitere Treiberschaltung 23 können gleich ausgestaltet sein, sie können aber auch unterschiedlich ausgestaltet sein.

Zu dem Leistungshalbleiterschalter 2 ist die weitere Freilaufdiode 24 parallel geschaltet, die von dem ersten Anschlusspunkt 13 zu dem Verbindungspunkt 14 in Sperrrichtung ausgerichtet ist.

Weiterhin ist der zweite Drosselanschluss 9 bei dem hier vorliegenden Ausführungsbeispiel mit dem dritten Anschlusspunkt 16 über einen Messwiderstand 28 verbunden und der zweite Drosselanschluss 9 mit einem Messanschluss 29 der Treiberschaltung 12. Hierdurch ist mit relativ wenig Aufwand eine Stromsensorik für den durch die Speicherdrossel 7 fließenden Strom realisiert, die beispielsweise für eine Regelung innerhalb der Treiberschaltung 12 verwendet werden kann.

Die leistungselektronische Wandlerschaltung 40 bildet in dem vorliegenden Ausführungsbeispiel einen sogenannten Synchronwandler, der eine Spannung zwischen dem ersten Anschlusspunkt 13 und dem zweiten Anschlusspunkt 15 in eine geringere Spannung zwischen dem dritten Anschlusspunkt 16 und dem zweiten Anschlusspunkt 15 umsetzen kann oder umgekehrt eine Spannung zwischen dem dritten Anschlusspunkt 16 und dem zweiten Anschlusspunkt 15 in eine höhere Spannung zwischen dem ersten Anschlusspunkt 13 und dem zweiten Anschlusspunkt 15 umsetzen kann. Die leistungselektronische Wandlerschaltung 40 in Fig. 3 kann somit als bidirektionaler Hoch- oder Tiefsetzsteller verwendet werden, je nachdem, welche der Anschlusspunkte als Ein- oder Ausgangsanschlüsse verwendet werden.

Die in der Schaltungsanordnung 1 in Fig. 3 vorliegende Reihenschaltung zweier Leistungshalbleiterschalter 2, 19 mit antiparallel geschalteten Dioden 24, 6 ist in der Leistungselektronik auch als Halbbrückenschaltung bekannt und bildet die Grundlage für Brückenschaltungen von Wechselrichtern oder Gleichrichtern, wie beispielsweise eine H-Brücke oder eine B6-Brücke. Die leistungselektronische Wandlerschaltung 40 bildet in dem vorliegenden Ausführungsbeispiel in Fig. 3 somit gleichermaßen auch einen Brückenzweig eines Wechselrichters oder eines Gleichrichters.

Für die Funktion der leistungselektronischen Wandlerschaltung 40 in Fig. 3 als Synchronwandler, bidirektionaler Hoch- oder Tiefsetzsteller, Wechselrichterbrückenzweig oder Gleichrichterbrückenzweig sind die Freilaufdiode 6 und die weitere Freilaufdiode 24 erforderlich.

Der Leistungshalbleiterschalter 2 und der weitere Leistungshalbleiterschalter 19 sind bei dem Ausführungsbeispiel in Fig. 3 beispielsweise als IGBTs ausgestaltet, sie können ebensogut beispielsweise als MOSFETs ausgestaltet sein.

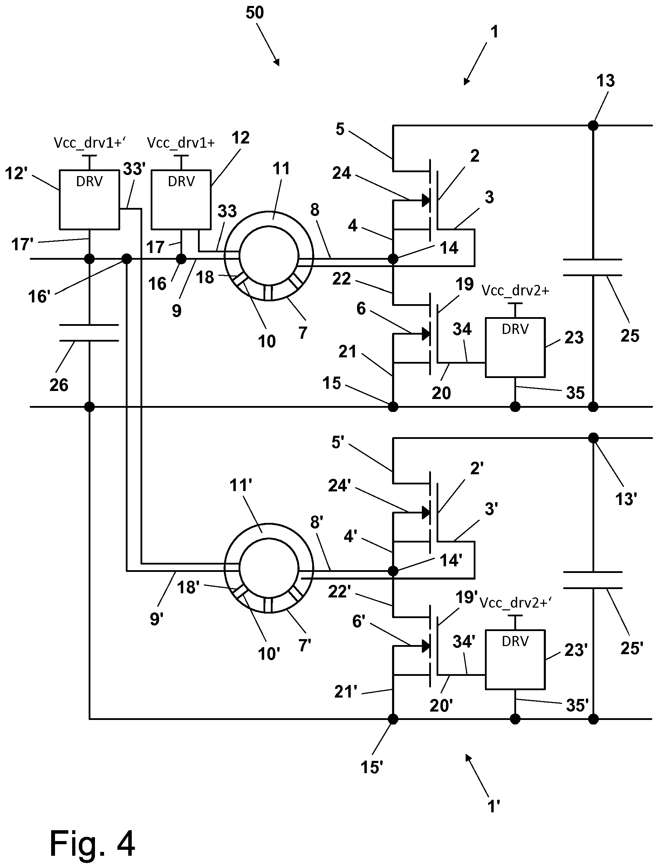

Fig. 4 zeigt eine leistungselektronische Wandlerschaltung 50 gemäß einem vierten Ausführungsbeispiel der Erfindung mit zwei erfindungsgemäßen Schaltungsanordnungen 1, 1'. Bei dem Ausführungsbeispiel einer erfindungsgemäßen leistungselektronischen Wandlerschaltung 50 in Fig. 4 als bidirektionaler Interleaved Hochsetzsteller sind zwei erfindungsgemäße Schaltungsanordnungen 1, 1', die jeweils bidirektionale Hochsetzsteller bilden, parallel geschaltet, indem die dritten Anschlusspunkte 16, 16' der beiden Schaltungsanordnungen 1, 1' miteinander verbunden sind und die zweiten Anschlusspunkte 15, 15' der beiden Schaltungsanordnungen 1, 1' miteinander verbunden sind und Eingangsanschlüsse der leistungselektronischen Wandlerschaltung 50 darstellen. Die ersten Anschlusspunkte 13, 13' und die zweiten Anschlusspunkte 15, 15' stellen Ausgangsanschlüsse des bidirektionalen Interleaved Hochsetzstellers dar. Die ersten Anschlusspunkte 13, 13' der beiden Schaltungsanordnungen 1, 1' können optional ebenfalls miteinander verbunden sein.

Es können bei einer erfindungsgemäßen leistungselektronischen Wandlerschaltung 50 auch mehr als zwei erfindungsgemäße Schaltungsanordnungen durch verbinden aller dritten Anschlusspunkte aller Schaltungsanordnungen und verbinden aller zweiten Anschlusspunkte aller Schaltungsanordnungen parallel geschaltet sein, wobei optional auch alle ersten Anschlusspunkte aller Schaltungsanordnungen verbunden sein können.

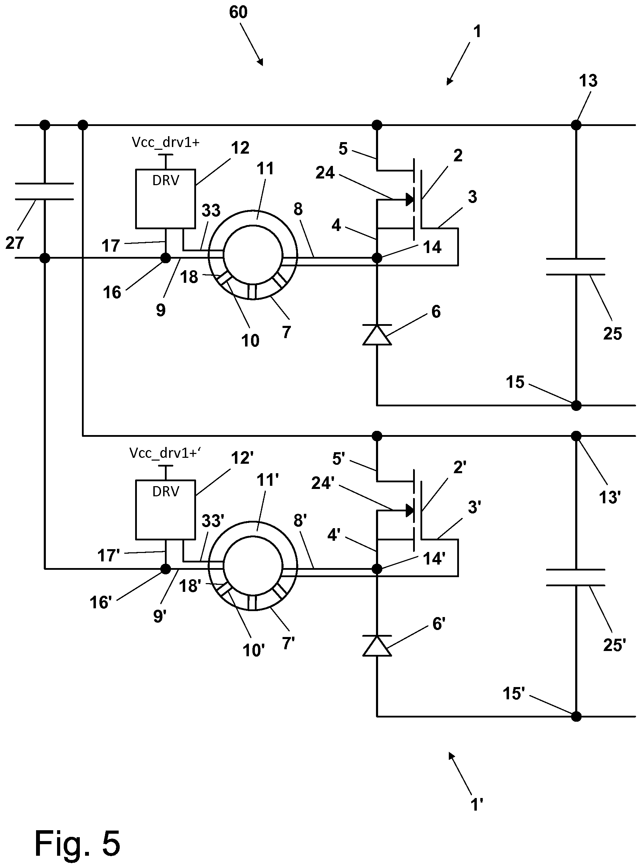

Fig. 5 zeigt schließlich noch ein fünftes Ausführungsbeispiel einer erfindungsgemäßen leistungselektronischen Wandlerschaltung 60 als unidirektionaler Interleaved Hochsetzsteller. Hier sind zwei erfindungsgemäße Schaltungsanordnungen 1, 1', die jeweils unidirektionale Hochsetzsteller bilden, parallel geschaltet, indem die dritten Anschlusspunkte 16, 16' der beiden Schaltungsanordnungen 1, 1' miteinander verbunden sind und die ersten Anschlusspunkte 13, 13' der beiden Schaltungsanordnungen 1, 1' miteinander verbunden sind und Eingangsanschlüsse der leistungselektronischen Wandlerschaltung 60 darstellen. Die ersten Anschlusspunkte 13, 13' und die zweiten Anschlusspunkte 15, 15' stellen Ausgangsanschlüsse des unidirektionalen Interleaved Hochsetzstellers dar, wobei die zweiten Anschlusspunkte 15, 15' der beiden Schaltungsanordnungen 1, 1' optional ebenfalls miteinander verbunden sein können.

Auch hier können bei einer erfindungsgemäßen leistungselektronischen Wandlerschaltung 60 mehr als zwei erfindungsgemäße Schaltungsanordnungen durch verbinden der dritten Anschlusspunkte aller Schaltungsanordnungen und verbinden aller ersten Anschlusspunkte aller Schaltungsanordnungen parallel geschaltet sein, wobei optional auch alle zweiten Anschlusspunkte aller Schaltungsanordnungen verbunden sein können.

Bei den Ausführungsbeispielen erfindungsgemäßer leistungselektronischer Wandlerschaltungen 50, 60 in den Fig. 4 und 5 sind die Bezugspotentialanschlüsse 17, 17' der Treiberschaltungen 12, 12' für die Leistungshalbleiterschalter 2, 2' mit den miteinander verbundenen dritten Anschlusspunkten 16, 16', und somit alle mit dem gleichen Bezugspotential verbunden. Dies erlaubt eine gemeinsame Nutzung von Teilen der Treiberschaltungen 12, 12' für die Leistungshalbleiterschalter 2, 2' für alle Schaltungsanordnungen 1, 1', wodurch sich der Schaltungsentwurf vereinfacht und der Schaltungsaufwand reduziert.

Die Erfindung ist nicht auf die explizit gezeigten Ausführungsformen beschränkt, sondern kann in vielfacher Art und Weise abgewandelt, insbesondere mit anderen gezeigten oder dem Fachmann bekannten Ausführungsformen kombiniert werden.

### Bezugszeichenliste

- 1, 1': Schaltungsanordnung
- 2, 2': Leistungshalbleiterschalter
- 3, 3': Steueranschluss
- 4, 4': Bezugspotentialanschluss
- 5, 5': gesteuerter Anschluss
- 6, 6': Freilaufdiode
- 7, 7': Speicherdrossel
- 8, 8': Drosselanschluss
- 9, 9': Drosselanschluss
- 10, 10': Wicklung
- 11, 11': Kern
- 12, 12': Treiberschaltung
- 13, 13': Anschlusspunkt
- 14, 14': Verbindungspunkt
- 15, 15': Anschlusspunkt
- 16, 16': Anschlusspunkt
- 17, 17': Bezugspotentialanschluss
- 18, 18': Wicklung
- 18a: Wicklung
- 18b: Wicklung
- 18c: Wicklung
- 19, 19': Leistungshalbleiterschalter
- 20, 20': Steueranschluss
- 21, 21': Bezugspotentialanschluss
- 22, 22': gesteuerter Anschluss
- 23, 23': Treiberschaltung
- 24, 24': Freilaufdiode
- 25, 25': Zwischenkreiskapazität
- 26: Zwischenkreiskapazität
- 27: Zwischenkreiskapazität
- 28: Messwiderstand
- 29: Messanschluss
- 30: Komponente
- 31: Komponente
- 32: Impedanz
- 33, 33': Signalanschluss
- 34, 34': Signalanschluss
- 35, 35': Bezugspotentialanschluss
- 40: Leistungselektronische Wandlerschaltung
- 50: Leistungselektronische Wandlerschaltung
- 60: Leistungselektronische Wandlerschaltung
- Vcc_drv1+: Spannungsversorgungssignal
- Vcc_drv1-: Spannungsversorgungssignal
- Vcc_drv2+: Spannungsversorgungssignal
- Vcc_drv1+': Spannungsversorgungssignal
- Vcc_drv2+': Spannungsversorgungssignal

## Patentansprüche

1. Schaltungsanordnung (1) umfassend einen Leistungshalbleiterschalter (2) mit einem Steueranschluss (3), einem Bezugspotentialanschluss (4) und einem gesteuerten Anschluss (5), eine Freilaufdiode (6), eine Speicherdrossel (7) mit einer Wicklung (10) zwischen einem ersten Drosselanschluss (8) und einem zweiten Drosselanschluss (9) sowie einem Kern (11), wobei die Speicherdrossel (7) zur Führung eines über den Leistungshalbleiterschalter (2) fließenden Stroms eingerichtet ist, und eine Treiberschaltung (12), die zur Ansteuerung des Leistungshalbleiterschalters (2) über dessen Steueranschluss (3) eingerichtet ist, wobei:
- der gesteuerte Anschluss (5) des Leistungshalbleiterschalters (2) mit einem ersten Anschlusspunkt (13) verbunden ist,
- der Bezugspotentialanschluss (4) des Leistungshalbleiterschalters (2) mit einem Verbindungspunkt (14) verbunden ist,
- der Verbindungspunkt (14) über die Freilaufdiode (6) mit einem zweiten Anschlusspunkt (15) verbunden ist, derart, dass die Freilaufdiode (6) von dem Verbindungspunkt (14) zu dem zweiten Anschlusspunkt (15) in Sperrrichtung ausgerichtet ist,
- der Verbindungspunkt (14) weiterhin mit dem ersten Drosselanschluss (8) verbunden ist, und
- der zweite Drosselanschluss (9) mit einem dritten Anschlusspunkt (16) verbunden ist,
wobei ein Bezugspotentialanschluss (17) der Treiberschaltung (12) direkt oder über eine Impedanz (32) mit dem dritten Anschlusspunkt (16) verbunden ist und wobei mindestens eine weitere Wicklung (18) mit der Wicklung (10) der Speicherdrossel (7) über den Kern (11) induktiv gekoppelt ist, wobei die mindestens eine weitere Wicklung (18) zur Führung eines Signals der Treiberschaltung (12) eingerichtet ist.

2. Schaltungsanordnung (1) nach Anspruch 1, wobei die mindestens eine weitere Wicklung (18) derart mit der Wicklung (10) der Speicherdrossel (7) induktiv gekoppelt ist, dass sich ein Spannungsabfall über der Wicklung (10) der Speicherdrossel (7) zu einer Spannung des Signals gegenüber einem Bezugspotential am dritten Anschlusspunkt (16) addiert.

3. Schaltungsanordnung (1) nach einem der Ansprüche 1 bis 2, wobei das Signal ein Signal ist, das den Leistungshalbleiterschalter (2) über dessen Steueranschluss (3) ansteuert.

4. Schaltungsanordnung (1) nach einem der Ansprüche 1 bis 3, wobei das Signal ein Spannungsversorgungssignal (Vcc_drv1+, Vcc_drv1-) der Treiberschaltung (12) ist.

5. Schaltungsanordnung (1) nach einem der Ansprüche 1 bis 4, wobei das Signal ein Signal zwischen zwei Komponenten (30, 31) der Treiberschaltung (12) ist.

6. Schaltungsanordnung (1) nach einem der Ansprüche 1 bis 5, weiterhin umfassend einen weiteren Leistungshalbleiterschalter (19) mit einem weiteren Steueranschluss (20), einem weiteren Bezugspotentialanschluss (21) und einem weiteren gesteuerten Anschluss (22) sowie eine weitere Treiberschaltung (23), die zur Ansteuerung des weiteren Leistungshalbleiterschalters (19) mit dem weiteren Steueranschluss (20) verbunden ist, wobei der weitere gesteuerte Anschluss (22) mit dem Verbindungspunkt (14) verbunden ist und der weitere Bezugspotentialanschluss (21) mit dem zweiten Anschlusspunkt (15) verbunden ist und weiterhin umfassend eine weitere Freilaufdiode (24), wobei der erste Anschlusspunkt (13) über die weitere Freilaufdiode (24) mit dem Verbindungspunkt (14) verbunden ist, derart, dass die weitere Freilaufdiode (24) von dem ersten Anschlusspunkt (13) zu dem Verbindungspunkt (14) in Sperrrichtung ausgerichtet ist.

7. Schaltungsanordnung (1) nach einem der Ansprüche 1 bis 6, wobei die induktive Kopplung zwischen der Wicklung (10) der Speicherdrossel (7) und der mindestens einen weiteren Wicklung (18) derart ausgestaltet ist, dass bei vollständiger oder partieller Sättigung des Kerns (11) die Kopplung derart reduziert wird, dass eine Differenzspannung entsteht, die direkt oder über eine der Komponenten (31) der Treiberschaltung bewirkt, dass der Leistungshalbleiterschalter (2) ausgeschaltet oder in einem linearen Betriebspunkt gehalten wird.

8. Schaltungsanordnung (1) nach einem der Ansprüche 1 bis 7, wobei die induktive Kopplung zwischen der Wicklung (10) der Speicherdrossel (7) und der mindestens einen weiteren Wicklung (18) derart ausgestaltet ist, dass die mindestens eine weitere Wicklung (18) eine Versorgungsleistung für die Treiberschaltung (12) bereitstellt.

9. Schaltungsanordnung (1) nach einem der Ansprüche 1 bis 8, wobei der zweite Drosselanschluss (9) mit dem dritten Anschlusspunkt (16) über einen Messwiderstand (28) verbunden ist und wobei der zweite Drosselanschluss (9) mit einem Messanschluss (29) der Treiberschaltung (12) verbunden ist.

10. Schaltungsanordnung (1) nach einem der Ansprüche 1 bis 9, wobei zwischen dem ersten Anschlusspunkt (13) und dem zweiten Anschlusspunkt (15) eine Kapazität (25) angeschlossen ist.

11. Schaltungsanordnung (1) nach einem der Ansprüche 1 bis 10, wobei zwischen dem dritten Anschlusspunkt (16) und dem zweiten Anschlusspunkt (15) eine Kapazität (26) angeschlossen ist.

12. Schaltungsanordnung (1) nach einem der Ansprüche 1 bis 10, wobei zwischen dem dritten Anschlusspunkt (16) und dem ersten Anschlusspunkt (13) eine Kapazität (27) angeschlossen ist.

13. Leistungselektronische Wandlerschaltung (40) mit einer Schaltungsanordnung (1) nach einem der Ansprüche 1 bis 12.

14. Leistungselektronische Wandlerschaltung (50) mit zwei Schaltungsanordnungen (1, 1') jeweils nach einem den Ansprüche 1 bis 11, wobei die dritten Anschlusspunkte (16, 16') der beiden Schaltungsanordnungen (1, 1') miteinander verbunden sind und die zweiten Anschlusspunkte (15, 15') der beiden Schaltungsanordnungen (1, 1') miteinander verbunden sind.

15. Leistungselektronische Wandlerschaltung (60) mit zwei Schaltungsanordnungen (1, 1') jeweils nach einem den Ansprüche 1 bis 10 oder nach Anspruch 12, wobei die dritten Anschlusspunkte (16, 16') der beiden Schaltungsanordnungen (1, 1') miteinander verbunden sind und die ersten Anschlusspunkte (13, 13') der beiden Schaltungsanordnungen (1, 1') miteinander verbunden sind.

## Claims

1. A circuit arrangement (1) comprising a power semiconductor switch (2) having a control terminal (3), a reference potential terminal (4) and a controlled terminal (5), a freewheeling diode (6), a storage choke (7) having a winding (10) between a first choke terminal (8) and a second choke terminal (9) and a core (11), wherein the storage choke (7) is configured for conducting a current flowing across the power semiconductor switch (2), and a driver circuit (12) that is configured for driving the power semiconductor switch (2) via the control terminal (3) thereof, wherein:
- the controlled terminal (5) of the power semiconductor switch (2) is connected to a first terminal point (13),
- the reference potential terminal (4) of the power semiconductor switch (2) is connected to a connection point (14),
- the connection point (14) is connected via the freewheeling diode (6) to a second terminal point (15) in a manner such that the freewheeling diode (6) is reverse-biased from the connection point (14) to the second terminal point (15),
- the connection point (14) is furthermore connected to the first choke terminal (8), and
- the second choke terminal (9) is connected to a third terminal point (16),
wherein a reference potential terminal (17) of the driver circuit (12) is connected to the third terminal point (16) directly or via an impedance (32), and wherein at least one further winding (18) is coupled inductively to the winding (10) of the storage choke (7) via the core (11), wherein the at least one further winding (18) is configured for conducting a signal of the driver circuit (12).

2. The circuit arrangement (1) as claimed in claim 1, wherein the at least one further winding (18) is inductively coupled to the winding (10) of the storage choke (7) in such a way that a voltage drop across the winding (10) of the storage choke (7) is added to a voltage of the signal with respect to a reference potential at the third terminal point (16).

3. The circuit arrangement (1) as claimed in either of claims 1 and 2, wherein the signal is a signal that drives the power semiconductor switch (2) via the control terminal (3) thereof.

4. The circuit arrangement (1) as claimed in any one of claims 1 to 3, wherein the signal is a voltage supply signal (Vcc_drv1+, Vcc_drv1-) of the driver circuit (12).

5. The circuit arrangement (1) as claimed in any one of claims 1 to 4, wherein the signal is a signal between two components (30, 31) of the driver circuit (12).

6. The circuit arrangement (1) as claimed in any one of claims 1 to 5, furthermore comprising a further power semiconductor switch (19) having a further control terminal (20), a further reference potential terminal (21), and a further controlled terminal (22), and a further driver circuit (23) that is connected to the further control terminal (20) for driving the further power semiconductor switch (19), wherein the further controlled terminal (22) is connected to the connection point (14) and the further reference potential terminal (21) is connected to the second terminal point (15), and furthermore comprising a further freewheeling diode (24), wherein the first terminal point (13) is connected via the further freewheeling diode (24) to the connection point (14) in a manner such that the further freewheeling diode (24) is reversed-biased from the first terminal point (13) to the connection point (14).

7. The circuit arrangement (1) as claimed in any one of claims 1 to 6, wherein the inductive coupling between the winding (10) of the storage choke (7) and the at least one further winding (18) is configured such that, in the case of complete or partial saturation of the core (11), the coupling is reduced such that a difference voltage occurs, which has the effect, directly or via one of the components (31) of the driver circuit, that the power semiconductor switch (2) is switched off or is kept in a linear operating point.

8. The circuit arrangement (1) as claimed in any one of claims 1 to 7, wherein the inductive coupling between the winding (10) of the storage choke (7) and the at least one further winding (18) is designed such that the at least one further winding (18) provides a supply power for the driver circuit (12).

9. The circuit arrangement (1) as claimed in any one of claims 1 to 8, wherein the second choke terminal (9) is connected via a measurement resistor (28) to the third terminal point (16), and wherein the second choke terminal (9) is connected to a measurement terminal (29) of the driver circuit (12).

10. The circuit arrangement (1) as claimed in any one of claims 1 to 9, wherein a capacitor (25) is connected between the first terminal point (13) and the second terminal point (15).

11. The circuit arrangement (1) as claimed in any one of claims 1 to 10, wherein a capacitor (26) is connected between the third terminal point (16) and the second terminal point (15).

12. The circuit arrangement (1) as claimed in any one of claims 1 to 10, wherein a capacitor (27) is connected between the third terminal point (16) and the first terminal point (13).

13. A power electronic converter circuit (40) having a circuit arrangement (1) as claimed in any one of claims 1 to 12.

14. A power electronic converter circuit (50) having two circuit arrangements (1, 1') each as claimed in any one of claims 1 to 11, wherein the third terminal points (16, 16') of the two circuit arrangements (1, 1') are connected to one another and the second terminal points (15, 15') of the two circuit arrangements (1, 1') are connected to one another.

15. A power electronic converter circuit (60) having two circuit arrangements (1, 1') each as claimed in any one of claims 1 to 10 or as claimed in claim 12, wherein the third terminal points (16, 16') of the two circuit arrangements (1, 1') are connected to one another and the first terminal points (13, 13') of the two circuit arrangements (1, 1') are connected to one another.

## Revendications

1. Circuit (1) comprenant un commutateur de puissance à semi-conducteurs (2) ayant une borne de commande (3), une borne de potentiel de référence (4) et une borne commandée (5), une diode de roue libre (6), une bobine d'accumulation (7) ayant un enroulement (10) entre une première borne de bobine (8) et une deuxième borne de bobine (9), et un noyau (11), dans lequel la bobine d'accumulation (7) est agencée pour conduire un courant passant par le commutateur de puissance à semi-conducteurs (2), et un circuit d'attaque (12) qui est agencé pour commander le commutateur de puissance à semi-conducteurs (2) par l'intermédiaire de sa borne de commande (3), dans lequel : - la borne commandée (5) du commutateur de puissance à semi-conducteurs (2) est connectée à un premier point de raccordement (13), - la borne de potentiel de référence (4) du commutateur de puissance à semi-conducteurs (2) est connectée à un point de connexion (14), - le point de connexion (14) est relié à un deuxième point de raccordement (15) par l'intermédiaire de la diode de roue libre (6) de telle sorte que la diode de roue libre (6) soit orientée dans le sens inverse du point de connexion (14) au deuxième point de raccordement (15), - le point de connexion (14) est en outre relié à la première borne de bobine (8) et - la deuxième borne de bobine (9) est reliée à un troisième point de connexion (16), une borne de potentiel de référence (17) du circuit d'attaque (12) étant reliée au troisième point de connexion (16) directement ou par l'intermédiaire d'une impédance (32), et au moins un autre enroulement (18) étant couplé par induction à l'enroulement (10) de la bobine d'accumulation (7) par l'intermédiaire du noyau (11), l'au moins un autre enroulement (18) étant prévu pour le transport d'un signal du circuit d'attaque (12).

2. Circuit (1) selon la revendication 1, dans lequel le au moins un autre enroulement (18) est couplé par induction à l'enroulement (10) de la bobine d'accumulation (7) de telle sorte qu'une chute de tension aux bornes de l'enroulement (10) de la bobine d'accumulation (7) est ajoutée à une tension du signal par rapport à un potentiel de référence au troisième point de raccordement (16).

3. Circuit (1) selon l'une quelconque des revendications 1 à 2, dans lequel le signal est un signal qui commande le commutateur de puissance à semi-conducteurs (2) par l'intermédiaire de sa borne de commande (3).

4. Circuit (1) selon l'une quelconque des revendications 1 à 3, dans lequel le signal est un signal d'alimentation en tension (Vcc_drv1+, Vcc_drv1-) du circuit d'attaque (12).

5. Circuit (1) selon l'une quelconque des revendications 1 à 4, dans lequel le signal est un signal entre deux composants (30, 31) du circuit d'attaque (12).

6. Circuit (1) selon l'une quelconque des revendications 1 à 5, comprenant en outre un autre commutateur de puissance à semi-conducteurs (19) ayant une autre borne de commande (20), une autre borne de potentiel de référence (21) et une autre borne commandée (22), et un autre circuit d'attaque (23) connecté à l'autre borne de commande (20) pour commander l'autre commutateur de puissance à semi-conducteurs (19), l'autre borne commandée (22) étant reliée au point de connexion (14) et l'autre borne de potentiel de référence (21) étant reliée au deuxième point de raccordement (15), et comprenant en outre une autre diode de roue libre (24), le premier point de raccordement (13) étant relié au point de connexion (14) par l'intermédiaire de l'autre diode de roue libre (24) de telle sorte que l'autre diode de roue libre (24) est orientée en sens inverse du premier point de raccordement (13) au point de connexion (14).

7. Circuit (1) selon l'une des revendications 1 à 6, le couplage inductif entre l'enroulement (10) de la bobine d'accumulation (7) et le au moins un autre enroulement (18) étant configuré de telle sorte que, en cas de saturation complète ou partielle du noyau (11), le couplage est réduit de manière à produire une tension différentielle qui, directement ou par l'intermédiaire de l'un des composants (31) du circuit d'attaque, provoque la coupure ou le maintien du commutateur de puissance à semi-conducteurs (2) à un point de fonctionnement linéaire.

8. Circuit (1) selon l'une des revendications 1 à 7, dans lequel le couplage inductif entre l'enroulement (10) de la bobine d'accumulation (7) et le au moins un autre enroulement (18) est configuré de telle manière que le au moins un autre enroulement (18) fournit une puissance d'alimentation pour le circuit d'attaque (12).

9. Circuit (1) selon l'une quelconque des revendications 1 à 8, dans lequel la deuxième borne de bobine (9) est reliée au troisième point de raccordement (16) par l'intermédiaire d'une résistance de mesure (28), et dans lequel la deuxième borne de bobine (9) est reliée à une borne de mesure (29) du circuit d'attaque (12).

10. Circuit (1) selon l'une des revendications 1 à 9, dans lequel une capacité (25) est connectée entre le premier point de raccordement (13) et le deuxième point de raccordement (15).

11. Circuit (1) selon l'une des revendications 1 à 10, dans lequel une capacité (26) est connectée entre le troisième point de raccordement (16) et le deuxième point de raccordement (15).

12. Circuit (1) selon l'une des revendications 1 à 10, dans lequel une capacité (27) est connectée entre le troisième point de raccordement (16) et le premier point de raccordement (13).

13. Circuit convertisseur électronique de puissance (40) comprenant un circuit (1) selon l'une quelconque des revendications 1 à 12.

14. Circuit convertisseur électronique de puissance (50) avec deux circuits (1, 1') selon l'une des revendications 1 à 11, les troisièmes points de raccordement (16, 16') des deux circuits (1, 1') étant reliés entre eux et les deuxièmes points de raccordement (15, 15') des deux circuits (1, 1') étant reliés entre eux.

15. Circuit convertisseur électronique de puissance (60) comprenant deux circuits (1, 1') selon l'une des revendications 1 à 10 ou selon la revendication 12, dans lequel les troisièmes points de raccordement (16, 16') des deux circuits (1, 1') sont reliés entre eux et les premiers points de raccordement (13, 13') des deux circuits (1, 1') sont reliés entre eux.
